Europäisches Patentamt

European Patent Office

Office européen des brevets

(11) Publication number: **0 097 326**
**B1**

## EUROPEAN PATENT SPECIFICATION

(45) Date of publication of patent specification: **28.01.87**

(51) Int. Cl.⁴: **H 01 L 21/76, H 01 L 27/08**

(21) Application number: **83105880.5**

(22) Date of filing: **15.06.83**

(54) Semiconductor device having a well structure.

(30) Priority: **18.06.82 JP 103826/82**

(43) Date of publication of application:
**04.01.84 Bulletin 84/01**

(45) Publication of the grant of the patent:
**28.01.87 Bulletin 87/05**

(84) Designated Contracting States:
**DE FR GB NL**

(56) References cited:
EP-A-0 021 776
EP-A-0 063 916
EP-A-0 074 541
EP-A-0 076 942
EP-A-0 078 890
EP-A-0 082 256
FR-A-2 140 383
US-A-4 178 605

I.E.E. 1st EUROPEAN SOLID STATE CIRCUITS
CONFERENCE, 1975, pages 28-29, London,
G.B., C. MULDER et al.: "High-speed I2L"

IBM TECHNICAL DISCLOSURE BULLETIN, vol.
24, no. 7B, December 1981, pages 3684-3688,
New York, USA, H.H. HANSEN et al.:
"Improved device packing density"

(73) Proprietor: **HITACHI, LTD.**
**6, Kanda Surugadai 4-chome Chiyoda-ku**
**Tokyo 100 (JP)**

(72) Inventor: **Yamamoto, Syuichi**
**3-1-3, Higashi-kogakubo**
**Kokubunji-shi Tokyo (JP)**
Inventor: **Hashimoto, Norikazu**
**168-90, Shimoyugi**
**Hachioji-shi Tokyo (JP)**
Inventor: **Sasaki, Toshio**
**1-48-18, Akatsuki-cho**
**Hachioji-shi Tokyo (JP)**
Inventor: **Masuhara, Toshiaki**
**2196-278, Hirai Hinode-machi**
**Nishitama-gun Tokyo (JP)**
Inventor: **Minato, Osamu**
**2196-660, Hirai Hinode-machi**
**Nishitama-gun Tokyo (JP)**
Inventor: **Tamaki, Yoichi**
**1-217, Higashi-Koigakubo**
**Kokubungi-shi Tokyo (JP)**
Inventor: **Hayashida, Tetsuya**
**2196-5, Hirai Hinode-machi**
**Nishitama-gun Tokyo (JP)**

(74) Representative: **Strehl, Peter, Dipl.-Ing. et al**
**Strehl, Schübel-Hopf, Schulz Patentanwälte**
**Widenmayerstrasse 17 Postfach 22 03 45**
**D-8000 München 22 (DE)**

## Description

Background of the Invention

The present invention relates to a semiconductor device for forming CMOS-structures which are applicable to the LSIs of a memory, a random logic, a microcomputer etc.

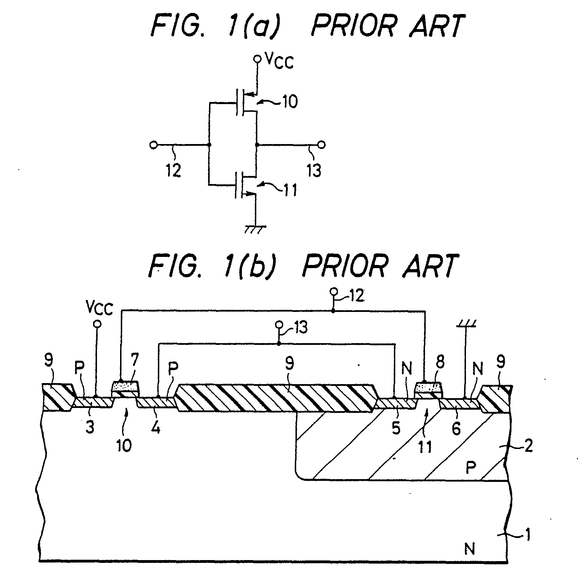

Heretofore, CMOS (Complementary Metal Oxide Semiconductor) circuits have been constructed of a fundamental inverter circuit shown in Fig. 1(a) and have had a sectional structure shown in Fig. 1(b). Such a device is disclosed in US 4 178 605. A similar device consisting of complementary MOS-elements and comprising a well region formed in a semiconductor substrate is shown in the French patent application 2 140 383. Referring to the figures, numeral 1 designates an n-type Si semiconductor substrate, numeral 2 a p-type well layer, numerals 3 and 4 p-type impurity layers, numerals 5 and 6 n-type impurity layers, and numerals 7 and 8 the gates of transistors, which are usually polycrystalline silicon layers. Shown at numeral 9 is an insulator film for isolation, such as $SiO_2$ film. The p-channel MOS transistor is constructed of the layers 3, 4 and 7, while the n-channel MCS transistor is constructed of the layers 5, 6 and 8, and the circuit designations of the respective transistors are numerals 10 and 11 in Fig. 1(a). Terminals 12 and 13 are input and output terminals, respectively.

In the semiconductor device having the above CMOS structure of the prior art, the circuit element is formed also in the predetermined region outside the well region 2 in correspondence with the element formed in this well region. Besides these circuit elements, an n-p-n bipolar transistor is parasitically formed of the substrate 1, well layer 2 and impurity layer 5. That is, the substrate 1 is regarded as a collector, the well layer 2 as a base, and the impurity layer 5 as an emitter. Also a lateral p-n-p bipolar transistor is parasitically formed of the impurity layer 4, substrate 1 and well layer 2. That is, the impurity layer 4 is regarded as an emitter, the substrate 1 as a base, and the well layer 2 as a collector. Also resistances of the substrate 1 and well layer 2 exist, and these elements constitute a thyristor as a whole. In this manner, when the well layer is disposed within the semiconductor substrate, a parasitic thyristor is inevitably formed. In the presence of such thyristor, when by way of example a great noise current is injected from the output terminal 13 into the p-type well layer 2 acting as the base of the parasitic n-p-n transistor, the thyristor is subjected to positive feedback, and a great current flows across a power supply terminal ($V_{cc}$) and a ground terminal, to destroy the device in the worst case. This is the abnormal phenomenon peculiar to the CMOS structure having heretofore been called "latch-up" (thyristor breakdown), and has been the most serious disadvantage of the CMOS structure. In order to overcome this disadvantage, the prior art cannot help taking the following measure. The base length of the parasitic p-n-p transistor, that is, the distance between the p-type impurity layer 4 and the p-type well layer 2 is set at a long interval of at least 10 µm, or the depth of the p-type well layer 2 acting as the base length of the parasitic n-p-n transistor is deliberately rendered great, whereby the current gain of the parasitic transistor is reduced so as to prevent the positive feedback to the thyristor and to avoid the latch-up phenomenon. Any of such measures, however, results in rendering the regions of the same conductivity type more distant than is necessary or widely spreading a region not required for the operation of the essential element, and it rather hampers enhancement in the density of integration of the device. For example, in terms of the occupying area per stage of an inverter, the CMOS circuit requires an occupying area which is about 1.4 times larger than that of an NMOS circuit, under the same pattern design rules.

Summary of the Invention

An object of the present invention is to overcome the disadvantage of the prior art inherent in the well structure as described above, and to provide a semiconductor device having a well structure which has a small occupying area and which can attain a high density of integration.

The construction of the present invention for accomplishing the object comprises a semiconductor substrate, a well region which is formed in the substrate, and an insulator layer which is made of a groove-like insulator and which is formed in the boundary part between the semiconductor subtrate and the well region so as to extend deeply into the substrate. The insulator layer is, at least, deeper than the well region and is provided along the side wall of the boundary. If necessary, it is formed so as to run on the extension of the wall in the depthwise direction. In addition, it is important for enhancement in the density of integration that the insulator layer is longer in its depthwise direction than in its widthwise direction.

Owing to the above construction of the present invention, even when the well region itself forms a certain conductive region (e.g., base region) of a parasitic transistor, the base current path of the parasitic transistor detours under the bottom of the insulator layer and becomes long, so that the base current of the parasitic transistor decreases, the injection efficiency thereof lowers, and the gain thereof diminishes drastically. As a result, the latch-up is hindered.

Therefore, the area of the well region can be made small, and the distance between an active element to be formed within the well region and another active element to be disposed outside the well region in correspondence with the former element is conspicuously shortened, which brings forth the effect of enhancing the density of integration.

In this manner, the present invention consists in that, in a circuit having one function such as an inverter circuit, an element constituting the circuit is isolated so as not to become a parasitic element or a part thereof, and it is essentially different in the object, construction and functional effect from the so-called isolation between conventional circuits or elements which incur no parasitic element (for example, the isoplanar technique, a technique utilizing LOCOS, etc.). Since the invention will be described in detail below in conjunction with embodiments, it will be clearly understood in order.

Brief Description of the Drawings

Figure 1(a) is a circuit diagram of an inverter circuit which employs CMOS transistors, while Figure 1(b) is a schematic sectional view of a prior-art semiconductor device which is applied to this circuit.

Figure 2 is a schematic sectional view of a semiconductor device as an embodiment of the present invention having a double-layer structured semiconductor substrate in which the insulator layer penetrates the low-impurity layer to reach the high-impurity layer of the substrate.

Figure 3(a) shows another example of a circuit to which the present invention is applied, while Figure 3(b) is a schematic sectional view thereof.

Figure 4 is a schematic sectional view showing still another circuit to which the present invention is applied.

Detailed Description of the Preferred Embodiments

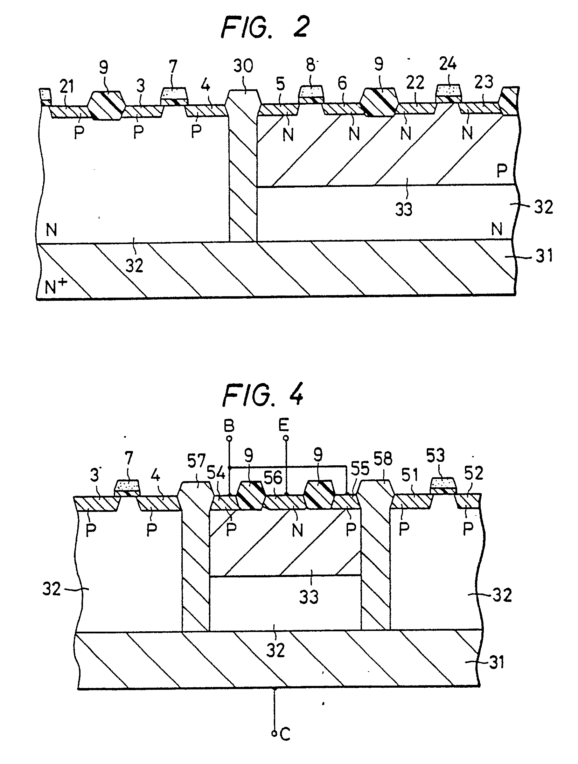

Figure 2 is a schematic sectional view of a semiconductor device which is an embodiment of the present invention. In the figure, numeral 21 designates a p-type impurity layer which corresponds to the layers 3 and 4 shown in Figure 1 (hereinbelow, this figure shall be referred to), numerals 22 and 23 n-type impurity layers which correspond to the layers 5 and 6, and numeral 24 a polycrystalline silicon layer as a gate electrode which corresponds to the layer 8. In addition, numeral 31 indicates a heavily-doped n-type semiconductor substrate, numeral 32 a lightly-doped n-type epitaxial layer, and numeral 33 a p-type well layer. According to the characterizing feature of the present embodiment, the semiconductor body has a double-layer structure in which a high impurity layer 31 is overlaid with a low impurity layer 32 and that an insulator layer 30, which penetrates the low impurity layer 32 to reach the high impurity layer 31, is disposed at the boundary part between the semi-conductor body 32 and the well layer 33.

The p-channel MOS transistor area and the n-channel MOS transistor area are perfectly isolated, by the insulator layer 30 and the high impurity layer 31. With the semiconductor device of the present example, notwithstanding that the resistivity of the heavily-doped n-type semiconductor substrate 31 is as very low as $0.1 \ \Omega \cdot cm$ or less, the base current of the parasitic transistor is substantially cut off, and hence, the latch-up phenomenon being the disadvantage of the prior art is, in effect, hindered.

So it is permitted to make the well region smaller. Thus, two objects contradictory to each other, namely preventing the latch-up phenomenon and enhancing the density of integration have been simultaneously solved.

Since the planar width of the insulator layer 30 is as small as 5 μm or less, the transistors can be disposed in proximity to each other, which is very advantageous for enhancing the density of integration. The groove width of the insulator layer may be shorter than the depth thereof. The groove width is usually 0.3—10 μm, and preferably 1—5 μm to the end of enhancing the density of integration. With a groove width smaller than 1 μm, difficulties are involved in the manufacturing process. Therefore, the groove width should of course be set scrupulously.

In forming the insulator layer 30, the known reactive sputter etching is restored to by employing, e.g., $Si_3N_4$ for a mask, whereby the deep groove whose side surface is substantially vertical is formed. The groove depth as predetermined is attained by adjusting the period of time of the sputtering. Subsequently, local oxidation is performed to form a thick $SiO_2$ film in the groove, and the $Si_3N_4$ film is removed. Thereafter, an $Si_3N_4$ film is deposited on the whole surface again. Next, polycrystalline silicon is buried into the groove and has its exposed part oxidized so as to wholly turn into an $SiO_2$ film. Thus, the insulator layer is formed. In the process for forming the insulator layer, more preferably an impurity opposite in the conductivity type to the substrate is introduced into the bottom of the groove to the end of preventing the appearance of a channel. Further, the $Si_3N_4$ film deposited on the whole surface in the latter half of the manufacturing process may well be omitted. The forming method mentioned above has exemplified the case of burying the polycrystalline silicon into the groove. As the burying material, however, a dielectric material such as $SiO_2$ or $Si_3N_4$ or a high polymer material can also be used unobjectionably. These materials have attained equal effects.

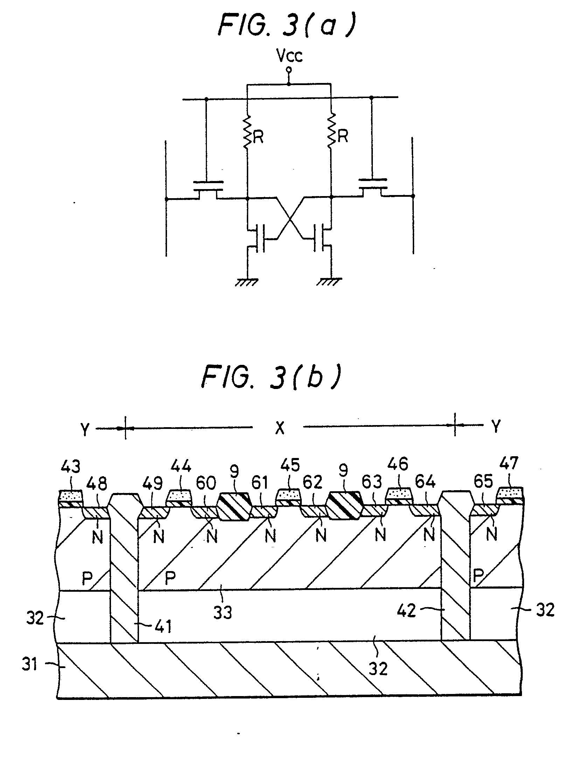

Figures 3(b) and 3(a) show a partial schematic sectional view of a semiconductor device as still another embodiment of the present invention, and a diagram of a circuit employing the semiconductor device, respectively. In case of constructing a memory, e.g., static type random access memory by the use of the CMOS structure, a flip-flop formed of nMOS transistors and high resistance loads R as shown in Figure 3(a) has heretofore been used as a memory cell thereof. This memory cell has as small a signal amplitude as 500 mV or less, and undergoes a malfunction due to noise from a peripheral circuit of large signal amplitude. In the present example, insulator layers 41 and 42 which are deep enough to reach the heavily-doped impurity layer 31 are disposed to perfectly isolate a memory cell portion X and peripheral circuit portions Y. As a result, the inflow of noise signals from the peripheral circuits has been avoided, and a semiconductor device of high reliability having a stable memory function has been obtained. In Figure 4(b), numerals 48, 49 and 60—65 denote n-type impurity layers, and numbers 43—47 polycrystalline silicon layers as the gates of MOS transistors.

Figure 4 shows a schematic sectional view of a semiconductor device which is yet another embodiment of the present invention. In the figure, numerals 51, 52, 54 and 55 indicate p-type impurity layers, and numeral 56 indicates an n-type impurity layer. This structure shows a vertical bipolar transistor which employs the layer 56 as its emitter E, the layers 54 and 55 as its base B and the layer 31 as its collector C. The bipolar transistor is formed in such a manner that it is isolated from another element, e.g., a p-channel MOS transistor formed of the layers 3, 4 and 7 or the layers 51, 52 and 53 by deep insulator layers 57 and 58 which form the characterizing feature of the present example. Thus, the bipolar transistor free from the latchup phenomenon and with a small occupying area can be fabricated, and the circuit operation performance can be enhanced.

Needless to say, when an impurity layer whose conductivity type is the same as that of the p-type well 33 and which has a comparatively high impurity density is formed to be shallower than the p-type well layer 33 from the semiconductor surface in the embodiment of the figure, the base length of the bipolar transistor becomes small to increase the parameter $h_{FE}$, so that a higher operating performance can be attained. The same impurity layer as stated above may well be formed in the semiconductor surface portion of the memory cell portion in Figure 3(b). In this case, most of electrons created within the semiconductor by the impingement of α-particles are excluded by the potential difference between the p-well layer 33 and the aforementioned inpurity layer. Therefore, the probability at which data of the memory cell is destroyed becomes very low, and a memory device of high reliability can be fabricated.

The embodiments have been explained as employing an insulator film such as of $SiO_2$ for the greater part in order to isolate elements formed in an identical semiconductor surface, for example, n- and p-channel MOS transistors, bipolar transistors, j-FETs, etc. Of course, even when any of them is individually formed by isolating it with narrow and deep insulator layers which characterize the present invention, the same effect is achieved.

The present invention has been explained as to a CMOS structure in which a p-type well is formed in an n-type substrate. However, even when they are formed in opposite conductivity types, an effect similar to the foregoing is attained. Since such construction is merely different in the symbols of the conductivity types, the detailed description is omitted.

## Claims

1. A semiconductor device having a semiconductor body of a first conductivity type, an impurity region (33) of a second conductivity type which is disposed in a selected part of a surface region of the body, and active elements which are respectively disposed in the semiconductor body and the impurity region so as to neighbour with each other, at least one of the active elements being an insulated-gate field effect transistor, and an insulator layer (30) disposed between active elements, characterized in that said semiconductor body of said first conductivity type has a double-layer structure in which a high impurity layer (31) is overlaid with a low impurity layer (32), and that said insulator layer (30; 41; 57; 58), which penetrates said low impurity layer (32) to reach said high impurity layer (31) and the depth of which is greater than the width thereof, and which is at least deeper than the impurity region (33), is disposed at a boundary part between said semiconductor body (32) and said impurity region (33) so as to isolate said active element(s) in said semiconductor body (32) from said active element(s) in said impurity region (33).

2. A semiconductor device as defined in claim 1, wherein said active elements disposed in said impurity region (33) constitute a memory cell circuit (x, y).

3. A semiconductor device as defined in claim 1, wherein a vertical bipolar transistor (31, 54 . . . 56) is formed in said impurity region (33).

4. A semiconductor device as defined in claim 1, wherein at least two active elements are disposed in said semiconductor body (32), at least two other active elements are disposed in said impurity region (33), and the elements in the same conductivity type portion are isolated from each other by insulator layer(s) (9) disposed therebetween and being not so deep as said impurity region.

5. A semiconductor device as defined in any of claims 1 to 4, wherein said active elements (10, 11) corresponding to each other are insulated-gate field effect transistors which form a CMOS structure.

6. A semiconductor device as defined in any of claims 1 to 4, wherein one (10) of said active elements is a P-channel MOS transistor, while the other (11) is an N-channel MOS transistor.

## Patentansprüche

1. Halbleitervorrichtung mit einem Halbleiterkörper eines ersten Leitungstyps, einem dotierten Gebiet (33) eines zweiten Leitungstyps, das in einem ausgewählten Teil des Oberflächengebietes des Halbleiterkörpers angeordnet ist, und mit aktiven Elementen, die jeweils im Halbleiterkörper und dem dotierten Gebiet so angeordnet sind, daß sie einander benachbart sind, wobei wenigstens eines der aktiven Elemente ein Feldeffekttransistor mit isoliertem Gate ist, und mit einer Isolierschicht (30) zwischen den aktiven Elementen, dadurch gekennzeichnet, daß der Halbleiterkörper des ersten Leitungstyps eine Doppelschicht-Struktur besitzt, bei der eine hochdotierte Schicht (31) von einer niedrigdotierten Schicht (32) überlagert ist, und daß die Isolatorschicht (30; 41; 57; 58), die die niedrigdotierte Schicht (32) durchdringt, um die hochdotierte Schicht (31) zu erreichen und deren Tiefe größer ist als ihre Breite und die wenigstens tiefer als das dotierte Gebiet (33) ist, in einem Randgebiet zwischen dem Halbleiterkörper (32) und dem dotierten Gebiet (33) so angeordnet ist, daß das (die) aktive(n) Element(e) in dem Halbleiterkörper (32) von dem (den) aktiven Element(en) in dem dotierten Gebiet (33) isoliert sind.

2. Halbleitervorrichtung nach Anspruch 1, bei dem die in dem dotierten Gebiet (33) angeordneten aktiven Elemente eine Speicherzellenschaltung (x, y) bilden.

3. Halbleitervorrichtung nach Anspruch 1, bei der in dem dotierten Gebiet (33) ein vertikaler bipolarer Transistor (31, 54 . . . 56) gebildet ist.

4. Halbleitervorrichtung nach Anspruch 1, bei der wenigstens zwei aktive Elemente in dem Halbleiterkörper (32) angeordnet sind, wenigstens zwei andere aktive Elemente in dem dotierten Gebiet (33) angeordnet sind, und die Elemente in dem Teil mit dem gleichen Leitungstyp voneinander durch (eine) Isolierschicht(en) (9) isoliert sind, die zwischen ihnen angeordnet ist (sind) und nicht so tief ist (sind) wie das dotierte Gebiet.

5. Halbleitervorrichtung nach einem der Ansprüche 1 bis 4, bei der die einander entsprechenden aktiven Elemente (10, 11) Feldeffekttransistoren mit isoliertem Gate sind, die eine CMOS-Struktur bilden.

6. Halbleitervorrichtung nach einem der Ansprüche 1 bis 4, bei der eines (10) der aktiven Elemente ein P-Kanal-MOS-Transistor ist, während das andere Element (11) ein N-Kanal-MOS-Transistor ist.

**Revendications**

1. Dispositif à semiconducteurs comportant un corps semiconducteur possédant un premier type de conductivité, une région d'impureté (33) possédant un second type de conductivité et qui est disposée dans une partie sélectionnée d'une région de la surface du corps, et des éléments actifs, qui sont disposés respectivement dans le corps semiconducteur et dans la région d'impureté de manière à être voisins les uns des autres, au moins l'un des éléments actifs étant un transistor à effet de champ à grille isolée, et une couche isolante (30) disposée entre des éléments actifs, caractérisé en ce que ledit corps semiconducteur possédant ledit premier type de conductivité possède une structure à deux couches, dans laquelle une couche (31) comportant une quantité élevée de l'impureté est recouverte par une couche (32) contenant une faible quantité de l'impureté, et que ladite couche isolante (30; 41; 57; 58), qui pénètre dans ladite couche (32) contenant une faible quantité de l'impureté et atteint ladite couche (31) contenant une quantité élevée de l'impureté et dont la profondeur est supérieure à sa largeur et qui est au moins plus profonde que la région d'impureté (33), est disposée au niveau d'une partie formant limite entre ledit corps semiconducteur (32) et ladite région d'impureté (33) de manière à isoler le ou lesdits éléments actifs situés dans ledit corps semiconducteur (32), du ou desdits éléments actifs situés dans ladite région d'impureté (33).

2. Dispositif à semiconducteurs selon la revendication 1, dans lequel lesdits éléments actifs disposés dans ladite région d'impureté (33) constituent un circuit de cellules de mémoire (x, y).

3. Dispositif à semiconducteurs selon la revendication 1, dans lequel un transistor bipolaire vertical (31, 54 . . . 56) est formé dans ladite région d'impureté (33).

4. Dispositif à semiconducteurs selon la revendication 1, dans lequel au moins deux éléments actifs sont disposés dans ledit corps semiconducteur (32), au moins deux autres éléments actifs sont disposés dans ladite région d'impureté (33) et les éléments situés dans la partie possédant le même type de conductivité sont isolés les uns des autres par une ou des couches isolantes (9) disposées entre eux et qui ne s'étendent pas aussi profondément que ladite région d'impureté.

5. Dispositif à semiconducteurs selon l'une quelconque des revendications 1 à 4, dans lequel lesdits éléments actifs (10, 11), qui se correspondent réciproquement, sont des transistors à effet de champ à grille isolée, qui forment une structure CMOS.

6. Dispositif à semiconducteurs selon l'une quelconque des revendications 1 à 4, dans lequel l'un (10) desdits éléments actifs est un transistor MOS à canal P, tandis que l'autre (11) est un transistor MOS à canal N.

## FIG. 1(a)  PRIOR ART

## FIG. 1(b)  PRIOR ART

## FIG. 2

## FIG. 4

# FIG. 3(a)

Vcc

R     R

# FIG. 3(b)

Y —|———— X ————|— Y

43  48    49  44  60  9  61  45  62  9  63  46  64    65  47

N      N    N      N      N      N    N    N

P      P

33        42

32                         32

41

31              32